# EUROPEAN PATENT SPECIFICATION

(11) **EP 1 847 162 B1**
(45) Date of publication and mention of the grant of the patent: **17.06.2009**
(21) Application number: 06701350.8
(22) Date of filing: 24.01.2006
(51) Int. Cl.: H05K 3/28

(54) **METHOD AND MACHINE FOR MANUFACTURING ELECTRICAL CIRCUITS**
VERFAHREN UND MASCHINE ZUR HERSTELLUNG ELEKTRISCHER SCHALTUNGEN
PROCEDE ET MACHINE SERVANT A FABRIQUER DES CIRCUITS ELECTRIQUES

(30) Priority: 31.01.2005 IT BO20050048
(43) Date of publication of application: 24.10.2007
(73) Proprietor: SPAL Automotive S.r.l., 42015 Correggio (Reggio Emilia) (IT)
(72) Inventor: SPAGGIARI, Alessandro, I-42015 Correggio (IT)
(74) Representative: Lanzoni, Luciano
(86) International application number: PCT/IB2006/000108
(87) International publication number: WO 2006/079894

(56) References cited:
- EP-A- 0 423 651
- US-A- 2 969 300
- US-A- 4 313 995
- US-A- 5 938 106
- US-A1- 2005 001 017

## Description

### Technical Field

This invention relates to a method for manufacturing electrical circuits.

In particular, but without thereby limiting its scope, the invention relates to a method for manufacturing electrical circuits for powering the brushes of electric motors.

### Background Art

In an electric motor, brush wear caused by the turning commutator leads to the formation of dust consisting of particles of electrically conductive material scattered around the commutator.

When used for motorcycle and automotive vehicle applications, the motors must be protected against infiltration, for example of rain water.

To obtain this type of protection, the motor guards are made watertight.

The watertight guards, however, trap the particles of electrically conductive material inside the casing, causing them to accumulate on the circuits and eventually creating short circuits or interrupting the power supply as a result of the creation of electrical bridges.

In the latter case, power is not distributed equally between the brushes and the balance required for correct operation is altered.

Methods of embedding electrical circuits, which are often formed or punched from a sheet or web of electrically conductive material, in the structure of the brush holder were therefore devised to overcome this problem.

This solution, however, although certainly effective, proved complex and expensive to implement.

Moreover, the circuits can be embedded only in brush holders made of plastic because the high melting point of metal would damage the electrical conductors during the forming process.

To overcome this problem, brush holders with recesses to precisely accommodate the circuits were made so that the circuits were exposed to dust only at the top.

This solution, however, while offering undoubted advantages in terms of simplicity has the drawback of not fully solving the problem of short circuiting and electrical bridging.

To overcome this drawback, a method of coating electrical circuits by dipping them in a suitable insulating material was devised.

This method of manufacturing electrical circuits, however, although it effectively insulates the circuits from electrically conductive dust, has evident disadvantages in terms of cost and complexity.

Indeed, after the circuit has been dipped in the insulating material and dried, the insulating material has to be removed from the parts of the circuit to be connected to the electrical conductors.

Owing to the very small size of the circuits, the operation of cleaning the contacts is difficult to perform and may result in poor electrical conduction. In other terms, it may give rise to the very problem that coating the circuit was designed to eliminate.

It is known, from US 2 969 300, a process for making printed circuits comprising the steps of advancing a continuous metal foil, unwound from a respective roller, through a punching station while a paper tape is applied to an under surface of the metal foil by means of adhesive. The punching station has a punch which presents a dinking die for cutting metal patterns from the metal foil. After the punching step, the metal patterns, adhering with the paper tape, are separated from the cut metal foil and are advanced through a coating station, wherein they are coated with an insulating material.

This invention therefore has for an aim to provide a method for manufacturing electrical circuits that is free of the above mentioned disadvantages and that is at once practical and inexpensive to implement.

### Disclosure of the Invention

The technical characteristics of the invention, with reference to the above aim may be clearly inferred from the contents of the appended claims, especially claim 1, and any of the claims that depend, either directly or indirectly, on claim 1.

This invention also relates to a machine for manufacturing electrical circuits.

The machine according to the invention is described in claim 11, and any of the claims that depend, either directly or indirectly, on claim 11.

### Brief Description of the Drawings

The technical characteristics of the invention, with reference to the above aims, are clearly described in the claims below and its advantages are apparent from the detailed description which follows, with reference to the accompanying drawings which illustrate a preferred embodiment of the invention provided merely by way of example without restricting the scope of the inventive concept, and in which:
Figure 1 is a schematic perspective view of a preferred embodiment of a machine for manufacturing electrical circuits according to the present invention;
Figures 2 to 7 illustrate a part of the machine of Figure 1 in a sequence of operating steps.

### Detailed Description of the Preferred Embodiments of the Invention

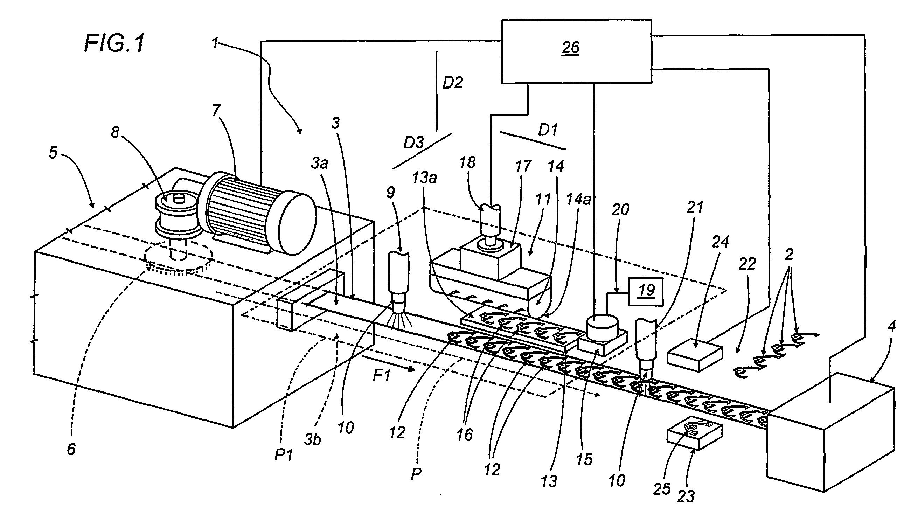

With reference to Figure 1, the numeral 1 denotes in its entirety a machine for manufacturing electrical circuits 2 from a web 3 of electrically conductive material.

The machine 1, which is represented schematically in the accompanying drawings, comprises means for feeding the web 3 along a defined feed path P.

The web feed means are represented schematically as a block 4.

The machine 1 also comprises a web cleaning station 5 equipped with one or more rotary brushes 6 and a pickling unit, not illustrated, the term "pickling" denoting a cleaning process performed by chemical or electrolytic means.

The brush 6 is rotationally driven by an electric motor 7 through a reduction unit 8.

At the outfeed end of the cleaning station 5, the machine 1 comprises a first unit 9, for drying the web 3, the unit 9 comprising an element 10 for blowing warm air on the web 3.

Downstream of the cleaning station 5, relative to the feed direction indicated by the arrow F1, the machine 1 comprises a stamping station 11 where a certain quantity of insulating varnish is applied to the web 3 in such a way as to form a plurality of impressions 12 on it. Each impression 12 covers a certain portion of the web 3 and reproduces the final form that the electrical circuit 2 will eventually have, though slightly larger in size.

The web 3 stamping station 11 comprises a pattern 13, a first pad 14 and second pad 15.

The pattern 13 is shaped substantially like a parallelepiped and has on its upper face 13a a plurality of cavities 16, each reproducing the above mentioned impression 12.

The cavities 16 are distributed in succession in a first direction D1 parallel to the straight section of the feed path P at the stamping station 11.

The first pad 14 is prismatic in shape, with a convex bottom face 14a, and is made of a resilient material, advantageously based on silicone.

The first pad 14 is mounted on a block 17 which is in turn stably connected to an operating arm 18.

The operating arm 18 is moved by actuating means, not illustrated in a second direction D2 perpendicular to a plane P1 in which the web 3 lies when it is at the stamping station.

The operating arm 18 is also moved by the same actuating means, not illustrated, in a third direction D3 perpendicular to the second direction D2 and parallel to the plane P1.

The second pad 15 is moved in reciprocating fashion by actuating means, which are not illustrated, in the above mentioned first direction D1 and, during its movement, engages the top face 13a of the pattern 13 and transfers a certain amount of insulating varnish to it.

The insulating varnish, stored in a tank that is schematically represented as a block 19, is fed by the tank to the second pad 15 through a conduit 20.

Similarly to what is described above, the machine 1 also comprises, at the outfeed end of the stamping station 11, a second drying unit 21 for quickly drying the insulating varnish applied to the web 3. The second drying unit 21 comprises an element 10 for blowing warm air on the web 3.

Downstream of the stamping station 11, the machine 1 further comprises a punching station 22 for cutting the circuits 2 out of the web 3 by punching.

As illustrated schematically in Figure 1, the punching station 22 comprises a die 23 and a matrix 24.

The die 23, shown under the web 3 in the accompanying drawings, has the design 25 of a circuit 2 made in it in relief, whilst the matrix 24, non illustrated in detail in the drawings, has on it the same design of the circuit 2 but in this case the design is recessed.

According to methods described in more detail below, the relief design 25 and the recessed design that is not illustrated engage each other and the web 3 in such a way as to punch out a circuit 2.

Downstream of the punching station 22, again relative to the direction indicated by the arrow F1, the machine 1 comprises the aforementioned web 3 feed means 4.

A block 26 in Figure 1 schematically represents a control unit. The control unit 26 controls and coordinates the operation and movement of all the parts of the machine 1.

In use, the web 3 of electrically conductive material is unwound from a roll, which is not illustrated in the drawings, and fed towards the cleaning station 5.

In the station 5, the web 3, which has a top face 3a and a bottom face 3b, is cleaned both by mechanical means and by pickling.

More specifically, mechanical cleaning is accomplished by brushing at least the top face 3a to which the varnish is applied, using the aforementioned rotary brushes 6, one of which is shown in Figure 1, drawn in dashed line style.

Pickling, as mentioned above, may be carried out either using suitable chemicals, selected according to the type of metal the web is made of, or by an electrolytic process. Both methods are well known in the trade and are not therefore described in this specification.

Still with reference to Figure 1, after leaving the cleaning station 5, the web 3, which is advanced in steps by the feed means 4, is struck at least on its top face 3a by a jet of warm air emitted by the blowing element 10 of the first drying unit 9.

The jet of warm air is designed to dry the top face 3a to remove any traces of liquid substances used during the previous, cleaning step.

Again with reference to Figure 1, the web 3 advances along the feed path P, in the direction indicated by the arrow F1, and reaches the stamping station 11.

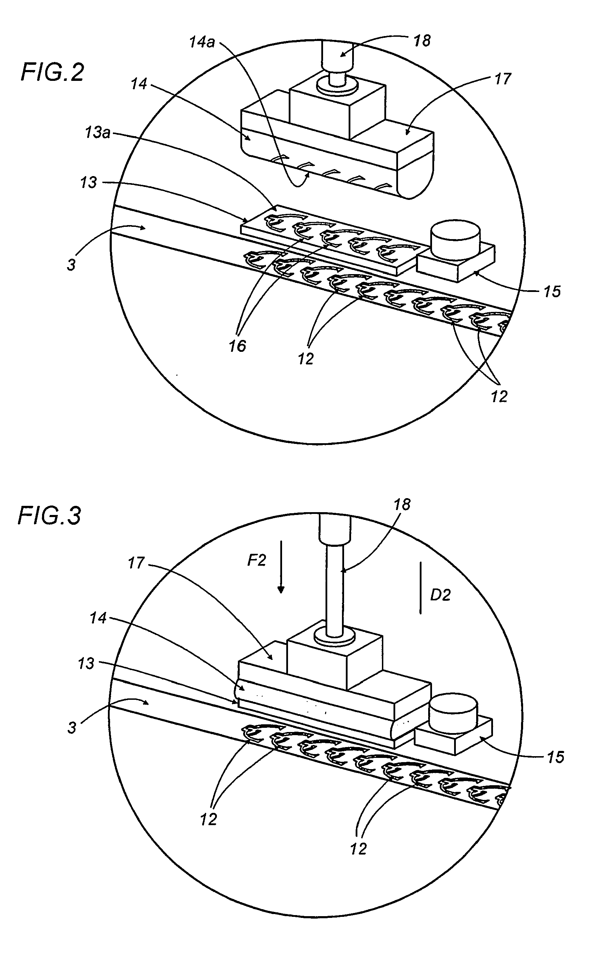

The following detailed description of the operations carried out at the stamping station 11 is made with reference to Figures 2 to 7, which are scaled-up views of the station 11 itself.

As shown in Figure 2, the operating arm 18, driven by respective actuating means that are not illustrated, positions the first pad 14 above the pattern 13 in such a way that the convex, bottom face 14a of the first pad 14 itself faces the top face 13a of the pattern 13.

The cavities 16 reproducing the impression 12 are full, that is to say, each cavity 16 contains a sufficient quantity of insulating varnish.

The operations by which they are filled are described in more detail below.

With reference to Figure 3, the operating arm 18 moves down in the direction D2, as indicated by the arrow F2, to place the first pad 14 in a first end position in which it is in contact with the top face 13a of the pattern 13. The first pad 14 is deformed by compression.

In Figure 3, the face 13a is hidden by the first pad 14.

At its aforementioned first end position, thanks to the high deformability of the material it is made of and to the compressive action exerted by the arm 18, the first pad 14 penetrates inside the cavities 16 of the pattern 13 and its bottom face 14a receives a certain quantity of varnish from the cavities 16.

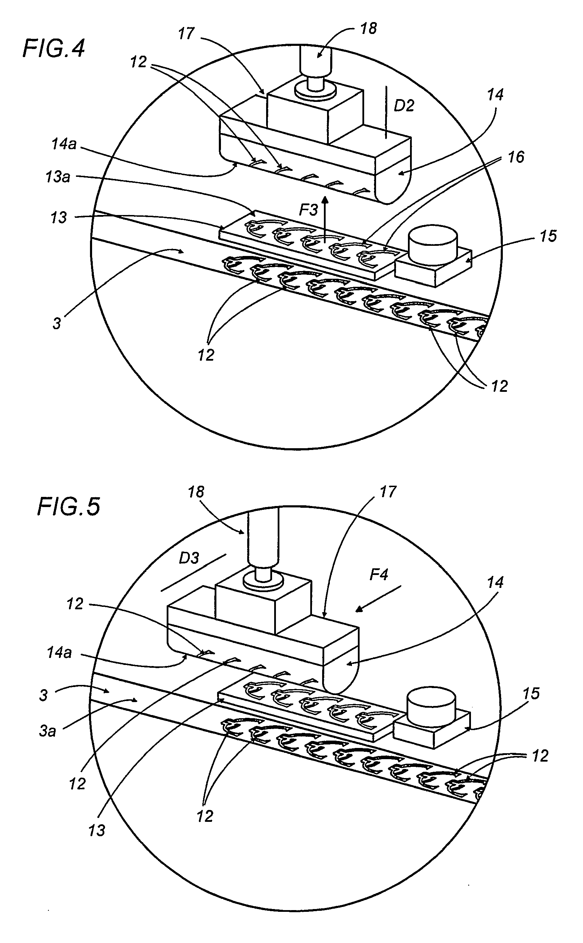

In other words, as clearly illustrated in Figure 4, some of the varnish that was previously inside the cavities 16 is transferred to the bottom face 14a according to the aforementioned impression 12.

Figure 4 shows the pad 14 after the arm 18 has lifted it in the direction of the arrow F3, causing the faces 13a, 14a of the pattern 13 and of the first pad 14, respectively, to move apart.

As shown in Figure 5, the arm 18, controlled by the unit 26, advances in the direction D3, as indicated by the arrow F4, and moves the first pad 14 to the position where its bottom face 14a faces the web 3 of electrically conductive material.

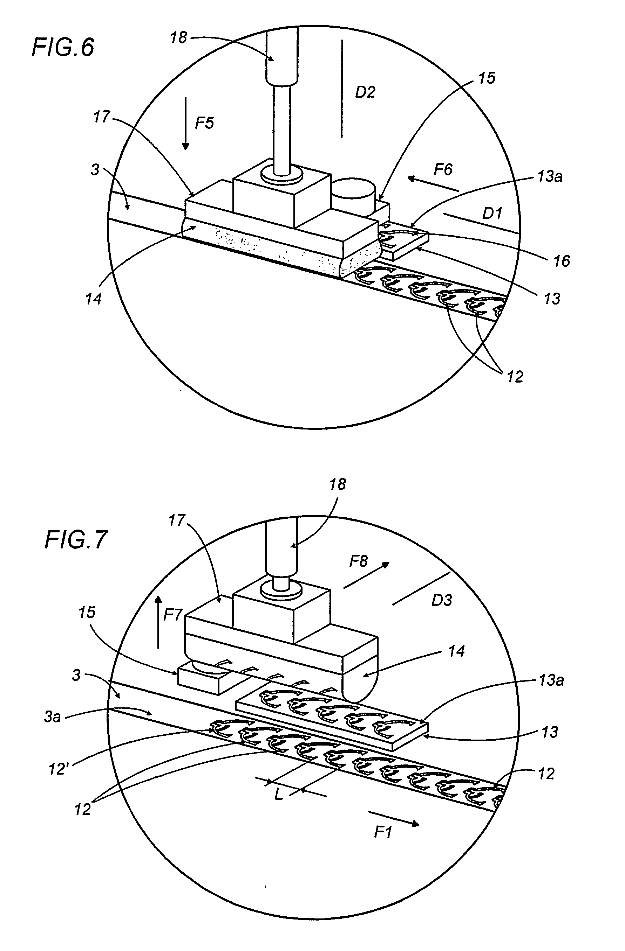

With reference to Figure 6, the arm 18 extends downwardly in the direction indicated by the arrow F5 and moves the first pad 14 down to a second end position in which it is in contact with the web 3 of electrically conductive material. The first pad 14 is deformed by compression.

At this second end position, the first pad 14 transfers to the top face 3a of the web 3 at least a part of the varnish that it had received in the form of impressions 12 on its bottom convex face 14a.

In Figure 6, the second pad 15 has started moving in the direction D1 indicated by the arrow F6 to meter the insulating varnish transferred to the top face 13a of the pattern 13.

More specifically, the second pad 15 moves over the pattern 13 twice and, as it does so, releases a quantity of insulating varnish that is transferred not only to the inside of the cavitities 16 but also to the smooth surface of the face 13a.

While releasing the varnish, the second pad 15 also exerts a scraping action on the top face 13a of the pattern 13. As a result of this scraping action, when the second pad 15 has moved over the pattern 13 for the second time, that is to say, when the second pad 15 has returned to the position shown in Figure 5, the insulating varnish is located only inside the cavities 16.

As illustrated in Figure 7, in which the arm 18 has already lifted the first pad 14 in the direction indicated by the arrow F7, another impression, labelled 12' for clarity, appears on the top face 3a of the web 3 as a result of the first pad 14 transferring insulating varnish when it is in its second end position, illustrated in Figure 6.

The working cycle of the first pad 14 is completed when the operating arm 18 moves back in the direction D3 as indicated by the arrow F8 to the position shown in Figure 2, ready to start another cycle.

While the first pad 14 performs this movement, the second pad 15 moves over the pattern 13 a second time in the direction indicated by the arrow F1 to return to the position illustrated in Figure 2, and the feed means 4 advance the web 3 along its path P in the direction indicated by the arrow F1, shown in Figures 1 and 7, by a step L equal to the spacing between one impression 12 and the next.

The spacing L between the impressions 12 made on the web 3 is equal to the spacing between the cavities 16 in the pattern 13.

Advantageously, a device, not illustrated, is positioned on the path P between the second drying unit 21 and the punching station 22 for applying a lubricating substance to the web 3, for example by spraying, in order to facilitate the cutting action of the punching die 23.

Advantageously, to enable the insulating varnish to be progressively layered on the web 3, the impressions 12 are obtained by repeated stamping actions of the first pad 14. For example, in the embodiment illustrated in the accompanying drawings, each finished impression 12 is made by the first pad 14 applying varnish to the web 3 in five successive stamping actions.

As illustrated in Figure 1, after leaving the stamping station 11, the web 3, which is advanced in steps by the feed means 4, is struck by a jet of warm air emitted by the blowing element 10 of the second drying unit 21.

This jet of warm air is designed to quickly dry the insulating varnish that has been applied to the web 3.

As it proceeds along the path P, each portion of the web 3 reaches the punching station 22 where it is engaged by the die 23 and the matrix 24.

The die 23 and matrix 24 move towards each other in substantially known manner and by means of actuators that are well known and therefore not described in detail in this specification, so as to engage each other and the web 3 to form the electrical circuits 2 by punching.

The die 23 which, through the relief design 25, physically cuts the electrical circuit 2 out of the web 3, engages the lower face 3b of the web 3, whilst the matrix 24 opposes the action of the die 23 by acting on the top face 3a.

Advantageously, in an alternative embodiment of the machine 1 that is not illustrated, the web 3 engages a feed roller which positions the web with its top face 3a - that is, the one on which the impressions 12 are made - down so that the electrical circuits 2 drop when they are punched out.

In this specification, the term "varnish" means any fluid insulating material that can be applied to a web of electrically conductive material and that will adhere permanently to the web.

In this specification the phrase "punch at least partly" denotes the fact that at least a part of the web portions coated with insulating varnish are cut out.

Indeed, for safety reasons, a part around the edges of the coated portions remain on the punched web. This is done for safety reasons because it would be extremely risky to cut out from the web a circuit that is not perfectly and completely coated with insulating varnish. It would indeed be extremely difficult and unduly expensive to provide means for exactly cutting out only the web portions that have been coated with varnish.

Advantageously, the web 3 that leaves the punching station 22, that is to say the part of the web from which the circuits 2 have been punched out, can easily be surface cleaned, melted down and re-used.

The invention described has evident industrial applications.

## Claims

1. A method for manufacturing electrical circuits (2), comprising:
- the step of step-feeding a web (3) of electrically conductive material along a path (P);
- the step of coating certain portions of the web (3) with an insulating varnish;
- the step of punching the given portions of the web (3) at least partly to define the electrical circuits (2);
the method being **characterised in that** the step of coating said certain portions of the web (3) takes place before the step of punching the given portions of the web (3).

2. The method according to claim 1, **characterised in that** the step of coating certain portions comprises the step of applying to the web (3) a given quantity of varnish to make a given impression (12).

3. The method according to claim 2, **characterised in that** the step of applying the varnish comprises the step of receiving the varnish from a pattern (13) and transferring the varnish to the web (3).

4. The method according to claim 3, **characterised in that** the step of applying the varnish to the web (3) is performed by a first pad (14) made of a resilient material.

5. The method according to claim 3 or 4, **characterised in that** it comprises a step of metering the varnish transferred to the pattern (13).

6. The method according to any of the claims from 2 to 5, **characterised in that** it comprises a step of drying the varnish applied to the web (3).

7. The method according to any of the claims from 1 to 6, **characterised in that** it comprises a step of cleaning at least one face (3a, 3b) of the web (3) to improve the adhesion of the varnish to the web (3) itself.

8. The method according to any of the claims from 1 to 7, **characterised in that** the cleaning step comprises the step of brushing the web (3).

9. The method according to any of the claims from 1 to 8, **characterised in that** the cleaning step comprises the step of pickling at least one face of the web (3).

10. The method according to any of the claims from 1 to 9, **characterised in that** it comprises a step of spraying a lubricating substance on the web (3) in order to facilitate the punching step.

11. A machine for manufacturing electrical circuits (2), comprising:
- means for feeding a web (3) of electrically conductive material along a path (P);
- a stamping station (11) for applying a given quantity of insulating varnish to given portions of the web (3);
- a punching station (22) for punching the given portions at least partly to define the electrical circuits (2);
the machine being **characterised in that** the stamping station (11) is located upstream than the punching station (22) with respect to said path (P).

12. The machine according to claim 11, **characterised in that** the stamping station (11) comprises a first pad (14) designed to apply a given quantity of varnish to the web (3) to make a given impression (12).

13. The machine according to claim 12, **characterised in that** it comprises a pattern (13) from which the first pad (14) receives the varnish to be applied to the web (3).

14. The machine according to claim 13, **characterised in that** the pattern (13) comprises a cavity (16) that reproduces the impression (12), the cavity (16) being designed to hold a certain quantity of the varnish.

15. The machine according to claim 14, **characterised in that** the pattern (13) comprises a plurality of cavities (16), the cavities (16) being distributed in succession in a first direction (D1) parallel to the web (3) feed path (P) at the stamping station (11).

16. The machine according to any of the claims from 13 to 15, **characterised in that** it comprises a second pad (15) for transferring the varnish to the pattern (13).

17. The machine according to any of the claims from 13 to 16, **characterised in that** the first pad (14) is mobile between a first end position in which it is in contact with the pattern (13) and where its face (14a) receives a given quantity of varnish in the shape of the impression (12), and a second end position in which it is in contact with the web (3) of electrically conductive material and where it at least partly transfers the given quantity of varnish to the web (3).

18. The machine according to any of the claims from 11 to 17, **characterised in that** it comprises step-feeding means (4) for advancing the web (3) in defined steps (L).

19. The machine according to claim 18 when it depends on claim 15, **characterised in that** the spacing between each of the plurality of cavities (16) on the pattern (13) and the cavity (16) adjacent to it is equal to the feed step (L) of the web (3).

20. The machine according to any of the claims from 11 to 19, **characterised in that** it comprises a station (5) for cleaning the web (3).

## Patentansprüche

1. Verfahren zur Herstellung elektrischer Schaltungen (2), bestehend aus:
- dem Schritt des schrittweisen Vorschubes einer Bahn (3) aus elektrisch leitfähigem Material entlang eines Weges (P);
- dem Schritt des Überziehens bestimmter Abschnitte der Bahn (3) mit einem Isolierlack;
- dem Schritt des zumindest teilweisen Ausstanzens der bestimmten Abschnitte der Bahn (3) zur Bildung der elektrischen Schaltungen (2);
wobei das Verfahren **dadurch gekennzeichnet ist, dass** der Schritt des Überziehens der bestimmten Abschnitte der Bahn (3) vor dem Schritt des Ausstanzens der bestimmten Abschnitte der Bahn (3) erfolgt.

2. Verfahren nach Anspruch 1, **dadurch gekennzeichnet, dass** der Schritt des Überziehens bestimmter Abschnitte den Schritt des Auftragens einer bestimmten Menge Lack auf die Bahn (3) beinhaltet, um einen vorgegebenen Abdruck (12) herzustellen.

3. Verfahren nach Anspruch 2, **dadurch gekennzeichnet, dass** der Schritt des Lackauftrages den Schritt der Aufnahme des Lacks von einem Klischee (13) und des Übertragens des Lackes auf die Bahn (3) beinhaltet.

4. Verfahren nach Anspruch 3, **dadurch gekennzeichnet, dass** der Schritt des Lackauftrages auf die Bahn (3) durch einen ersten Drucktampon (14) aus elastischem Material ausgeführt wird.

5. Verfahren nach Anspruch 3 oder 4, **dadurch gekennzeichnet, dass** es einen Schritt zum Dosieren des auf das Klischee (13) gegebenen Lackes beinhaltet.

6. Verfahren nach einem der Ansprüche von 2 bis 5, **dadurch gekennzeichnet, dass** es einen Schritt des Trocknens des auf die Bahn (3) aufgetragenen Lackes beinhaltet.

7. Verfahren nach einem der Ansprüche von 1 bis 6, **dadurch gekennzeichnet, dass** es einen Schritt des Reinigens zumindest einer Fläche (3a, 3b) der Bahn (3) beinhaltet, um das Anhaften des Lackes auf der Bahn (3) zu verbessern.

8. Verfahren nach einem der Ansprüche von 1 bis 7, **dadurch gekennzeichnet, dass** der Reinigungsschritt den Schritt des Abbürstens der Bahn (3) beinhaltet.

9. Verfahren nach einem der Ansprüche von 1 bis 8, **dadurch gekennzeichnet, dass** der Reinigungsschritt den Schritt des Abbeizens zumindest einer Fläche der Bahn (3) beinhaltet.

10. Verfahren nach einem der Ansprüche von 1 bis 9, **dadurch gekennzeichnet, dass** es einen Schritt des Aufsprühens eines Schmiermittels auf die Bahn (3) beinhaltet, um den Schritt des Ausstanzens zu erleichtern.

11. Maschine zur Herstellung elektrischer Schaltungen (2), bestehend aus:
- Einrichtungen für den Vorschub einer Bahn (3) aus elektrisch leitfähigem Material entlang eines Weges (P);
- einer Druckstation (11) zum Auftragen einer bestimmten Menge an Isolierlack auf bestimmte Abschnitte der Bahn (3);
- einer Stanzstation (22) zum zumindest teilweisen Ausstanzen der bestimmten Abschnitte zur Bildung der elektrischen Schaltungen (2);
wobei die Maschine **dadurch gekennzeichnet ist, dass** die Druckstation (11) bezogen auf den Weg (P) stromaufwärts vor der Stanzstation (22) angeordnet ist.

12. Maschine nach Anspruch 11, **dadurch gekennzeichnet, dass** die Druckstation (11) einen ersten Drucktampon (14) beinhaltet, der dafür ausgelegt ist, eine bestimmte Menge Lack auf die Bahn (3) aufzutragen, um einen vorgegebenen Abdruck (12) herzustellen.

13. Maschine nach Anspruch 12, **dadurch gekennzeichnet, dass** sie ein Klischee (13) beinhaltet, von dem der erste Drucktampon (14) den auf die Bahn (3) aufzutragenden Lack entnimmt.

14. Maschine nach Anspruch 13, **dadurch gekennzeichnet, dass** das Klischee (13) eine Aushöhlung (16) beinhaltet, die den Abdruck (12) nachbildet, wobei die Aushöhlung (16) dafür ausgelegt ist, eine bestimmte Menge Lack aufzunehmen.

15. Maschine nach Anspruch 14, **dadurch gekennzeichnet, dass** das Klischee (13) mehrere Aushöhlungen (16) beinhaltet, wobei diese Aushöhlungen (16) aufeinanderfolgend entlang einer ersten Richtung (D1) verteilt angeordnet sind, die parallel zu dem Vorschubweg (P) der Bahn (3) an der Druckstation (11) verläuft.

16. Maschine nach einem der Ansprüche von 13 bis 15, **dadurch gekennzeichnet, dass** sie einen zweiten Drucktampon (15) zum Übertragen des Lacks auf das Klischee (13) beinhaltet.

17. Maschine nach einem der Ansprüche von 13 bis 16, **dadurch gekennzeichnet, dass** der erste Drucktampon (14) beweglich ist zwischen einer ersten Endlage, in der er das Klischee (13) berührt und in der er mit seiner Fläche (14a) eine bestimmte Menge Lack in Form des Abdruckes (12) aufnimmt, und einer zweiten Endlage, in der er die Bahn (3) aus elektrisch leitfähigem Material berührt und in der er zumindest teilweise die bestimmte Menge Lack auf die Bahn (3) überträgt.

18. Maschine nach einem der Ansprüche von 11 bis 17, **dadurch gekennzeichnet, dass** sie Schrittvorschubeinrichtungen (4) beinhaltet, um die Bahn (3) in festgelegten Schritten (L) vorzuschieben.

19. Maschine nach Anspruch 18, sofern von Anspruch 15 abhängig, **dadurch gekennzeichnet, dass** der Abstand zwischen jeder der mehreren Aushöhlungen (16) auf dem Klischee (13) und der jeweils benachbarten Aushöhlung (16) gleich einem Vorschubschritt (L) der Bahn (3) ist.

20. Maschine nach einem der Ansprüche von 11 bis 19, **dadurch gekennzeichnet, dass** sie eine Station (5) zum Reinigen der Bahn (3) beinhaltet.

## Revendications

1. Un procédé pour fabriquer des circuits électriques (2), comprenant :
- la phase consistant à faire avancer par pas une bande (3) de matériau électriquement conducteur le long d'un parcours (P) ;
- la phase consistant à recouvrir des parties données de la bande (3) avec un vernis isolant ;
- la phase consistant à poinçonner au moins partiellement lesdites parties données de la bande (3) pour définir les circuits électriques (2) ;
le procédé étant **caractérisé en ce que** la phase consistant à recouvrir lesdites parties données de la bande (3) a lieu avant la phase consistant à poinçonner ces mêmes parties données de la bande (3).

2. Le procédé selon la revendication 1, **caractérisé en ce que** la phase consistant à recouvrir des parties données comprend la phase consistant à appliquer sur la bande (3) une quantité donnée de vernis pour réaliser une empreinte donnée (12).

3. Le procédé selon la revendication 2, **caractérisé en ce que** la phase consistant à appliquer le vernis comprend la phase consistant à recevoir le vernis d'un patron (13) et à transférer le vernis sur la bande (3).

4. Le procédé selon la revendication 3, **caractérisé en ce que** la phase consistant à appliquer le vernis sur la bande (3) est effectuée par un premier tampon (14) réalisé dans un matériau résilient.

5. Le procédé selon la revendication 3 ou 4, **caractérisé en ce qu'**il comprend une phase consistant à doser le vernis transféré sur le patron (13).

6. Le procédé selon l'une quelconque des revendications de 2 à 5, **caractérisé en ce qu'**il comprend une phase consistant à sécher le vernis appliqué sur la bande (3).

7. Le procédé selon l'une quelconque des revendications de 1 à 6, **caractérisé en ce qu'**il comprend une phase consistant à nettoyer au moins une face (3a, 3b) de la bande (3) pour améliorer l'adhérence du vernis sur la bande (3) elle-même.

8. Le procédé selon l'une quelconque des revendications de 1 à 7, **caractérisé en ce que** la phase de nettoyage comprend la phase consistant à brosser la bande (3).

9. Le procédé selon l'une quelconque des revendications de 1 à 8, **caractérisé en ce que** la phase de nettoyage comprend la phase consistant à décaper au moins une face de la bande (3).

10. Le procédé selon l'une quelconque des revendications de 1 à 9, **caractérisé en ce qu'**il comprend une phase consistant à pulvériser une substance lubrifiante sur la bande (3) afin de faciliter la phase de poinçonnage.

11. Une machine pour fabriquer des circuits électriques (2), comprenant :
- des moyens pour faire avancer une bande (3) de matériau électriquement conducteur le long d'un parcours (P) ;
- une station de marquage (11) pour appliquer une quantité donnée de vernis isolant sur des parties données de la bande (3) ;
- une station de poinçonnage (22) pour poinçonner au moins partiellement lesdites parties données afin de définir les circuits électriques (2) ;
la machine étant **caractérisée en ce que** la station de marquage (11) est située en amont de la station de poinçonnage (22) par rapport audit parcours (P).

12. La machine selon la revendication 11, **caractérisée en ce que** la station de marquage (11) comprend un premier tampon (14) destiné à appliquer une quantité donnée de vernis sur la bande (3) pour réaliser une empreinte donnée (12).

13. La machine selon la revendication 12, **caractérisée en ce qu'**elle comprend un patron (13) duquel le premier tampon (14) reçoit le vernis à appliquer sur la bande (3) .

14. La machine selon la revendication 13, **caractérisée en ce que** le patron (13) comprend une cavité (16) qui reproduit l'empreinte (12), la cavité (16) étant destinée à contenir une quantité donnée de vernis.

15. La machine selon la revendication 14, **caractérisée en ce que** le patron (13) comprend une pluralité de cavités (16), les cavités (16) étant réparties en succession dans une première direction (D1) qui est parallèle au parcours (P) d'avance de la bande (3) au niveau de la station de marquage (11).

16. La machine selon l'une quelconque des revendications de 13 à 15, **caractérisée en ce qu'**elle comprend un deuxième tampon (15) pour transférer le vernis sur le patron (13).

17. La machine selon l'une quelconque des revendications de 13 à 16, **caractérisée en ce que** le premier tampon (14) est mobile entre une première position limite dans laquelle il est en contact avec le patron (13) et dans laquelle sa face (14a) reçoit une quantité donnée de vernis selon la forme de l'empreinte (12), et une deuxième position limite dans laquelle il est en contact avec la bande (3) de matériau électriquement conducteur et dans laquelle il transfère au moins partiellement la quantité donnée de vernis sur la bande (3).

18. La machine selon l'une quelconque des revendications de 11 à 17, **caractérisée en ce qu'**elle comprend des moyens d'avance par pas (4) pour faire avancer la bande (3) par pas (L) définis.

19. La machine selon la revendication 18 quand dépendant de la revendication 15, **caractérisée en ce que** l'espacement entre chaque cavité de la pluralité de cavités (16) du patron (13) et la cavité (16) adjacente est égal au pas (L) d'avance de la bande (3).

20. La machine selon l'une quelconque des revendications de 11 à 19, **caractérisée en ce qu'**elle comprend une station (5) pour le nettoyage de la bande (3).
